# EUROPÄISCHE PATENTANMELDUNG

(11) **EP 3 876 053 A1**
(43) Veröffentlichungstag der Anmeldung: **08.09.2021**
(21) Anmeldenummer: 20160979.9
(22) Anmeldetag: 04.03.2020
(51) Int. Cl.: G05B 19/418, H04L 1/00, H03M 13/03

(54) **VERFAHREN ZUR AUFDECKUNG VON ADRESSIERUNGSFEHLERN UND FELDGERÄT**

(71) Anmelder: Siemens Aktiengesellschaft, 80333 München (DE)
(72) Erfinder: Bär, Alexandra, 92260 Ammerthal (DE); Hubert, Johannes, 90559 Burgthann (DE); Maier, Mario, 92266 Ensdorf (DE); Schmauss, Wolfgang, 90607 Rückersdorf (DE); Taschke, Ulrich, 90766 Fürth (DE); Wahrbichler, Joachim, 8043 Graz (AT); Walter, Maximilian, 90408 Nürnberg (DE)

(57) **Zusammenfassung**

Zur Aufdeckung von Adressierungsfehlern bei einer fehlersicheren Kommunikations-Verbindung zwischen einem Automatisierungsgerät (PLC1,PLC2) und einem Feldgerät (D1,D2,D3), wobei für die fehlersichere Kommunikations-Verbindung eine F-Adresse (F-Adr) genutzt wird, welche einen Codenamen (CN1,CN2,-CN3) und eine Basiskennung (BID1,BID2,BID3) umfasst, wird vorgeschlagen mit einer Rechenregel (f₍₎) mit zumindest einem Wert (BID1_L,BID1_H, welcher aus der ersten Basiskennung (BID1) abgeleitet wurde, auf eine neue Blockprüfzeichenfolge (FCS) zu errechnen, und die derart berechnete neue Blockprüfzeichenfolge (FCS') wird in der Nachricht (M1) versendet,
- wobei zur Aufdeckung eines Adressierungsfehlers im ersten Feldgerät (D1) zunächst aus der neuen Blockprüfzeichenfolge (FCS') unter Zuhilfenahme der Rechenregel (f₍₎) mit dem zumindest einen Wert (BID_L,BID_H) die Blockprüfzeichenfolge (FCS) zurückgerechnet wird und mit Hilfe einer Prüfsummenprüfung (34,CRC) aus den zu empfangenen Daten (22) und aus dem Statusbyte (SC) unter Einwirkung des für diese Verbindung vergebenen ersten Codenamen (CN1) eine erwartete Blockprüfzeichenfolge (FCSₑ) errechnet wird,
- wobei die erwartete Blockprüfzeichenfolge (FCSₑ) mit der zurückgerechneten Blockprüfzeichenfolge (FCS) verglichen wird und bei Ungleichheit wird eine Fehlermeldung erzeugt.

## Beschreibung

Die Erfindung betrifft ein Verfahren zur Aufdeckung von Adressierungsfehlern bei einer fehlersicheren Kommunikations-Verbindung zwischen einem Automatisierungsgerät und einem Feldgerät, wobei für die fehlersichere Kommunikations-Verbindung eine F-Adresse genutzt wird, welche einen Codenamen und eine Basiskennung umfasst, wobei für das Senden einer Nachricht von dem Automatisierungsgerät zu dem Feldgerät mit Hilfe einer Prüfsummenberechnung aus zu versendenen Daten und aus einem Statusbyte unter Einwirkung des für die jeweilige Verbindung vergebenen Codenamen, eine Blockprüfzeichenfolge gebildet wird.

Auch betrifft die Erfindung ein Feldgerät, ausgestaltet zur Aufdeckung von Adressierungsfehlern bei einer fehlersicheren Kommunikations-Verbindung mit einem Automatisierungsgerät, wobei für die fehlersichere Kommunikations-Verbindung eine F-Adresse genutzt wird, welche einen Codenamen und eine Basiskennung umfassen.

Im Sinne der Erfindung wird unter fehlersicherer Kommunikations-Verbindung, die Definition der funktionalen Sicherheit bei Kommunikation in Automatisierungsanlagen aus der Norm IEC 61508 verstanden.

Bekannt ist, dass durch technische oder organisatorische Maßnahmen sichergestellt wird, dass bei einer sicheren Verbindungs-Identifizierung zwischen zwei Kommunikationsteilnehmern in einem Kommunikationssystem, ein Telegramm, ein lokales Netz des Kommunikationssystems nicht verlassen kann. Für eine fehlersichere Verbindung werden innerhalb des lokalen Netzes des Kommunikationssystems Adresskennungen eindeutig vergeben. In einem Anwendungsfall für spezielle Serienmaschinen, bei welchem zwei Kommunikationsnetze auftreten, müssen zwischen den Kommunikationsnetzen der Serienmaschinen Netztrenner installiert werden, die dafür sorgen, dass die Telegramme das jeweilige lokale Netz nicht verlassen können.

Die Systembeschreibung "PROFIsafe Systembeschreibung, Technologie und Anwendung", Version November 2010, Bestell-Nr. 4.3.4.1, Herausgeber Profibusnutzerorganisation e.V. XP-000896541, beschreibt die Realisierung einer sicherheitsgerichteten Kommunikation und insbesondere eine sichere Verbindungsidentifizierung bei Profibus- und Profinet-Protokollen.

Bei dem bekannten Verfahren zur sicherheitsgerichteten Kommunikation, insbesondere in der Automatisierungstechnik muss eine Adressbeziehung, umfassend eine Ziel- und eine Quelladresse, beispielsweise von Profinet-Teilnehmern, netzweitig eindeutig sein.

Als Beispiel für ein sicherheitsgerichtetes Kommunikationsprotokoll sei das Sicherheitsprotokoll PROFIsafe genannt. Bei PROFIsafe wird ein 32-Bit Codename, welcher einer Adressbeziehung entspricht, zur eindeutigen Verbindungsidentifizierung genutzt. Der Nachteil hieran ist, die Codenamen können nicht weltweit eindeutig vergeben werden.

Im Hinblick auf einen zukünftigen Kommunikations-Standard, nämlich dem OPC-UA Standard, werden Hersteller von Serienmaschinen die als nicht akzeptabel angesehen.

Eine F-Adresse, ist eine eindeutige Adressbeziehung zwischen zwei Kommunikationsteilnehmern. Die F-Adresse dient in einer auf funktionale Sicherheit ausgelegten Kommunikation der eindeutigen Identifikation von einer Quelle und einem Ziel. Jede F-Peripherie hat deshalb zwei Adressanteile F-Quelladresse, F-Zieladresse. Ein oder beide Adressanteile können dabei zur Absicherung verwendet werden.

Bei PROFIsafe-Verbindungen wird beispielsweise zur Adressfehlererkennung ein eindeutiger Codename zugewiesen (32-Bit). In einer Industrieanlage darf dieser nicht mehrfach vorkommen, was durch organisatorische Maßnahmen (z.B. Liste oder Datenbank) sichergestellt werden muss.

Bei einem Einsatz von Serienmaschinen (z.B. 200 identische Gehänge einer Elektrohängebahn oder 50 identische fahrerlose Transportsysteme) soll für alle Instanzen dasselbe Engineering-Projekt verwendet werden, ansonsten müsste ein Kunde der zu automatisierende Industrieanlage bezogen auf die Elektrohängebahn, beispielsweise 200 einzelne Projekte speichern und verwalten. Dies ist nicht gewünscht.

Und im Hinblick auf eine Erweiterung des Profinet Protokolls für IP-Netze, ist eine weltweite Eindeutigkeit geplant. Mit den bisherigen Verfahren können Adressierungsfehler zu Geräten außerhalb der eigenen Anlage nicht ausgeschlossen werden. Es ist daher ein Wunsch auch weltweit eindeutig adressieren zu können.

Im Hinblick auf eine Kommunikation innerhalb einer Serienmaschine ist es bereits bekannt, jede Serienmaschine mit einer eigenen BID (Base-Identifier) zu versorgen. Das bedeutet, wenn jede Instanz (Serienmaschine) intern dieselben Codenamen verwendet, aber jeweils eine unterschiedliche BID besitzt, ist eine Kombination aus BID und Codename dann weltweit mit hoher Wahrscheinlichkeit eindeutig.

Im laufenden Betrieb können dann der Codename und die BID bei einer CRC-Berechnung (Sender) und CRC-Prüfung (Empfänger) berücksichtigt werden. Das bedeutet, eine in einem Telegramm versendete Frame Check Sequence (FCS) hängt von dem Codenamen und der BID ab. Bei einem Adressierungsfehler würde entweder der Codename oder die BID im Empfänger nicht mit dem jeweiligen erwarteten Wert übereinstimmen. Eine CRC-Prüfung würde daher mit hoher Wahrscheinlichkeit fehlschlagen.

Der Nachteil des beschriebenen Verfahrens im Zusammenhang mit beispielsweise PROFIsafe liegt darin, dass der nachträgliche Einbau der zuvor erwähnten Prüfung mit einer BID, in beispielsweise ein Feldgerät als Kommunikationsteilnehmer, einen Eingriff in sicherheitsrelevante Teile des Gerätes erfordern würde. Das bedeutet, eine Anpassung der PROFIsafe-Schicht (PROFIsafe Treiber) wäre erforderlich. Da ein Entwicklungsprozess sicherheitsbezogener Komponenten sehr aufwändig ist und einen anschließenden Test nachzieht und weiter eventuell eine erneute TÜV Zertifizierung nach sich zieht und es sehr viele unterschiedliche Geräte gibt (I/O-Baugruppen, Antriebe, ...), wäre dieses insgesamt mit einem nicht vertretbaren hohen Aufwand zu bewerkstelligen und es würden hohe Entwicklungskosten entstehen.

Es ist demnach die Aufgabe der vorliegenden Erfindung ein Verfahren anzugeben, bei dem eine fehlersichere Kommunikation zwischen einem Automatisierungsgerät und einem Feldgerät auch weltweit möglich wird und dabei eventuelle Adressierungsfehler aufzudecken, ohne dass Änderungen an der Profsafe-Schicht in einem Feldgerät durchgeführt werden müssen.

Vorgeschlagen zur Lösung der Aufgabe wird demnach ein Verfahren, das beispielsweise in sicherheitsbezogene Geräte wie I/O-Baugruppen-Antrieben etc. implementiert werden kann, ohne Änderung an sicherheitsbezogene Softwareschichten vornehmen zu müssen.

Bezogen auf das eingangs genannte Verfahren wird die Aufgabe dann dadurch gelöst, dass ausgehend von einem ersten Automatisierungsgerät mit einer ersten Basiskennung als Sender der Nachricht für ein erstes Feldgerät als Empfänger der Nachricht aus der bereits berechneten Blockprüfzeichenfolge eine neue Blockprüfzeichenfolge generiert wird, wobei eine Anwendung einer Rechenregel mit zumindest einem Wert, welcher aus der ersten Basiskennung abgeleitet wurde, auf die Blockprüfzeichenfolge die neue Blockprüfzeichenfolge ergibt, und die derart berechnete neue Blockprüfzeichenfolge wird in der Nachricht versendet, wobei zur Aufdeckung eines Adressierungsfehlers im ersten Feldgerät zunächst aus der neuen Blockprüfzeichenfolge unter Zuhilfenahme der Rechenregel mit dem zumindest einen Wert die Blockprüfzeichenfolge zurückgerechnet wird und mit Hilfe einer Prüfsummenprüfung aus den zu empfangenen Daten und aus dem Statusbyte unter Einwirkung des für diese Verbindung vergebenen ersten Codenamen eine erwartete Blockprüfzeichenfolge errechnet wird, wobei die erwartete Blockprüfzeichenfolge mit der zurückgerechneten Blockprüfzeichenfolge verglichen wird und bei Ungleichheit wird eine Fehlermeldung erzeugt.

Mit anderen Worten wird nun erfindungsgemäß vorgeschlagen, im Sender nach einer Berechnung der Frame-Check-Sequence (FCS), Werte, die aus der Basiskennung (BID) abgeleitet wurden, mit der FCS zu verknüpfen (z.B. mittels exklusiver Disjunktion) (XOR)), und die erhaltene manipulierte FCS, FCS', im Telegramm zu versenden. Im Empfänger wird dann nun vor Prüfung der wirklichen FCS, mit Werten, die aus der BID die jetzt zusätzlich im Empfänger hinterlegt ist, mit der FCS' welche aus dem erhaltenen Telegramm entnommen ist, verknüpft (z.B. mittel exklusiver Disjunktion (XOR)), so dass die ursprüngliche FCS wieder hergestellt wird. Durch diesen Trick ist in der gesendeten FCS' die Information der Basiskennung (BID) enthalten und kann in dem Empfängergerät, sprich in dem Feldgerät, nachgeprüft werden.

In einer Weiterbildung des Verfahrens wird der Schritt bei dem aus der neuen Blockprüfzeichenfolge unter Zuhilfenahme der Rechenregel mit dem zumindest einen Wert die Blockprüfzeichenfolge zurückgerechnet wird und bezogen auf einen Schichtenaufbau in dem Feldgerät, dieser in einem nicht-Sicherheitslayer durchgeführt und die restlichen Schritte werden in einem Sicherheitslayer des Feldgerätes ausgeführt. Bei dieser Ausgestaltung des Verfahrens hat man die Möglichkeit, den Adressbestandteil des Automatisierungsgerätes, nämlich die Basiskennung (BID) zu prüfen, ohne in die Sicherheitsebene des Feldgerätes einzugreifen.

Eine weitere Verbesserung des Verfahrens erhält man, wenn man aus der Basiskennung einen ersten Wert und einen zweiten Wert ableitet und der erste Wert einer ersten Rangfolge von Bits und der zweite Wert einer zweiten Rangfolge von Bits der Basiskennung entspricht.

Eine nochmalige Optimierung des Verfahrens bzw. eine Erhöhung der Wahrscheinlichkeit einer Aufdeckung eines Fehlers wird dadurch erreicht, dass zur Generierung der neuen Blockprüfzeichenfolge ein Toggle-Bit aus dem Statusbyte genutzt wird um abwechselnd den ersten Wert oder den zweiten Wert zu verwenden.

Das erfindungsgemäße Ziel ist es schließlich, dass zuvor genannte Verfahren in Feldgeräten anzuwenden, welche als sicherheitsbezogene Geräte für die Prozessautomatisierung bereits ausgelegt sind, wobei das Verfahren ausgeführt werden kann ohne Änderungen an sicherheitsbezogenen Software-Schichten des Gerätes vornehmen zu müssen.

Der Vorteil dieses Verfahrens liegt darin, dass beispielsweise bei PROFIsafe für die nachträgliche Prüfung der Basiskennung (BID) kein Eingriff in sicherheitsrelevante Teile des Gerätes erforderlich werden. Das hat den Vorteil, dass eine Anpassung der PROFIsafe-Schicht nicht erforderlich ist und dementsprechend auch kein erhöhter Entwicklungsaufwand auf das Testen und Abändern von sicherheitsgerichteten Komponenten entsteht.

Die eingangs genannte Aufgabe wird vorrichtungsgemäß durch ein Feldgerät gelöst, welches ausgestaltet ist, zur Aufdeckung von Adressierungsfehlern bei einer fehlersicheren Kommunikationsverbindung mit einem Automatisierungsgerät, wobei für die fehlersichere Kommunikations-Verbindung eine F-Adresse genutzt wird, welche einen Codenamen und eine Basiskennung umfasst, wobei für das Senden einer Nachricht von dem Automatisierungsgerät zu den Feldgerät mit Hilfe einer Prüfsummenberechnung aus zu versendenden Daten und aus einem Statusbyte unter Einwirkung des für die jeweilige Verbindung vergebenen Codenamen eine Blockprüfzeichenfolge gebildet wird, und wobei durch eine Anwendung einer Rechenregel mit zumindest einem Wert, welcher aus der jeweiligen Basiskennung abgeleitet wurde, auf die Blockprüfzeichenfolge eine neue Blockprüfzeichenfolge ergibt, und die derart berechnete neue Blockprüfzeichenfolge ist in der Nachricht enthalten und wird so vom Feldgerät empfangen, weiterhin ausgestaltet mit einer Aufteilung in eine sichere Schicht, in welcher sicherheitsbezogene Softwareanteile ablauffähig hinterlegt sind und in eine nicht sichere Schicht in der losgelöst von den sicherheitsgerichteten Aufgaben nicht auf Sicherheit ausgelegte Anwendungen ablaufen, wobei in der nicht sicheren Schicht ein Zusatzmittel zur Aufnahme einer Basiskennung-Erweiterung vorhanden ist, und ein Speicherbereich vorhanden ist, in welcher für die fehlersichere Kommunikationsverbindung die zugehörige Basiskennung abgespeichert ist, und die Basiskennungs-Erweiterung ausgestaltet ist, zur Aufdeckung eines Adressierungsfehlers zunächst aus der in der Nachricht enthaltenen Blockprüfzeichenfolge unter Zuhilfenahme der Rechenregel mit dem Wert, welcher jetzt als der abgespeicherten Basiskennung abgeleitet wird, die Blockprüfzeichenfolge zurückzurechnen, und in der sicheren Schicht ein Mittel zur Prüfsummenprüfung vorhanden ist, welches aus den zu empfangenen Daten und aus dem Statusbyte unter Einwirkung des für diese Verbindung V vergebenen ersten Codenamen eine erwartete Blockprüfzeichenfolge errechnet wird und eine Schnittstelle vorhanden ist, welche ausgestaltet ist, die erwartete Blockprüfzeichenfolge aus der nicht sicheren Schicht entgegenzunehmen, und ein Vergleichsmittel vorhanden ist, welches die erwartete Blockprüfzeichenfolge mit der zurückgerechneten Blockprüfzeichenfolge vergleicht.

Die Zeichnung zeigt ein Ausführungsbeispiel der Erfindung. Dabei zeigen
- FIG 1: eine erste Serienmaschine verbunden mit einer zweiten Serienmaschine,
- FIG 2: einen Sendevorgang in einem Automatisierungsgerät,
- FIG 3: einen Empfangsvorgang in einem Feldgerät,
- FIG 4: eine Übersicht von einem Sender und Empfänger mit aufgeteilten Schichten in sicher und nicht sicher,

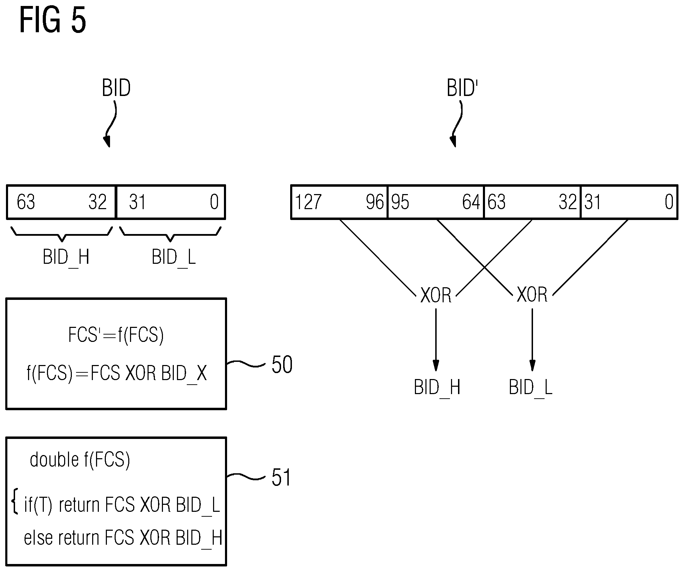

- FIG 5: ein Beispiel zur Ableitung von Werten aus einer Basiskennung,
- FIG 6: den erfindungsgemäßen Sendevorgang,
- FIG 7: den erfindungsgemäßen Empfangsvorgang und
- FIG 8: ein Blockschaltbild eines Feldgerätes.

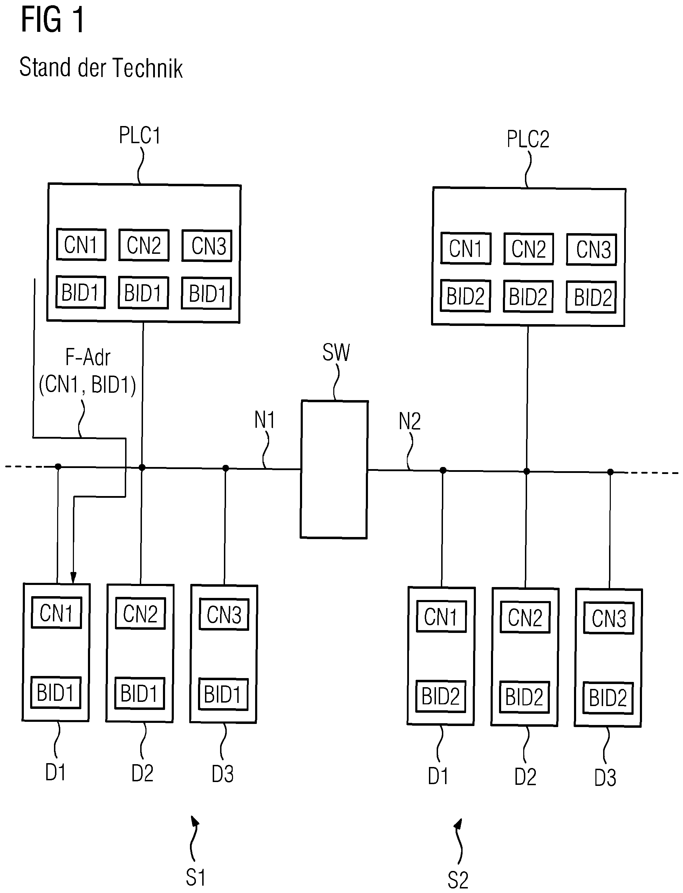

Gemäß FIG 1 (Stand der Technik) ist eine erste Serienmaschine S1 über ein erstes Netzwerk N1 mit einem Switch SW an eine zweite Serienmaschine S2, welche über ein Netzwerk N2 an den Switch SW angeschlossen ist, verbunden. Die erste Serienmaschine S1 weist ein erstes Automatisierungsgerät PLC1 auf, an welches ein erstes Feldgerät D1, ein zweites Feldgerät D2 und ein drittes Feldgerät D3 über das erste Netzwerk N1 angeschlossen sind. Zwischen dem ersten Automatisierungsgerät PLC 1 und den Feldgeräten D1,D2,D3 wird eine fehlersichere Kommunikations-Verbindung durchgeführt. Für die fehlersichere Kommunikations-Verbindung bzw. F-Verbindungen sind F-Adressen Bestandteil der Projektierung des ersten Automatisierungsgerätes PLC1 und der Feldgeräte D1,D2,D3. Eine Verbindung von dem ersten Automatisierungsgerät PLC1 zu dem ersten Feldgerät D1 ist beispielhaft eingezeichnet, wobei für die F-Adresse F-ADR CN1,BID1 eingetragen ist. In dem ersten Automatisierungsgerät PLC1 sind demzufolge für die aufzubauenden Verbindung zu den Feldgeräten D1,D2,D3 entsprechende Codenamen für die Verbindungen hinterlegt. Ein erster Codename CN1 steht für eine Verbindung zum ersten Feldgerät D1, ein zweiter Codename CN2 steht für eine Verbindung zum zweiten Feldgerät D2 und ein dritter Codename CN3 steht für eine Verbindung zum dritten Feldgerät D3. Die Adressbeziehung der F-Adresse ist in dem ersten Automatisierungsgerät PLC1 demnach als Pärchen aus CN1,BID1;CN2,BID1;CN3,BID1 hinterlegt. Entsprechend ist in dem jeweiligen Feldgerät D1,D2,D3 auch das Pärchen der Adressbeziehung hinterlegt, wobei das erste Feldgerät D1 den Codenamen CN1, das zweite Feldgerät D2 den Codenamen CN2 und das dritte Feldgerät D3 den Codenamen CN3 aufweist. Da aber alle von einem übergeordneten Feldgerät, nämlich dem ersten Automatisierungsgerät PLC1 (Master) angesprochen werden, haben die Feldgeräte D1,D2,D3 alle die gleiche Basiskennung, nämlich die erste Basiskennung BID1.

Für die zweite Serienmaschine S2 gilt das zuvor gesagte analog, wobei es sich nun um ein zweites Automatisierungsgerät PLC2 handelt. Dem zweiten Automatisierungsgerät PLC2 ist für eine Adresseindeutigkeit eine zweite Basiskennung BID2 zugeordnet. Die zu den zweiten Automatisierungsgerät PLC2 zugehörigen Feldgeräte D1,D2,D3 weisen ebenfalls die zweite Basiskennung BID2 auf.

Gemäß der FIG 1 kann nun auch über Netzwerkgrenzen hinweg, eine weltweit eindeutige Adressierung gewährleistet werden. Der entscheidende Nachteil bei der Lösung aus FIG 1 ist, dass in den Feldgeräten D1,D2,D3 eine Änderung an einer sicherheitsgerichteten Schicht, z.B. PROFIsafe-Schicht, vorgenommen werden muss um den bzw. die erste Basiskennung BID1 oder die zweite Basiskennung BID2 einzufügen.

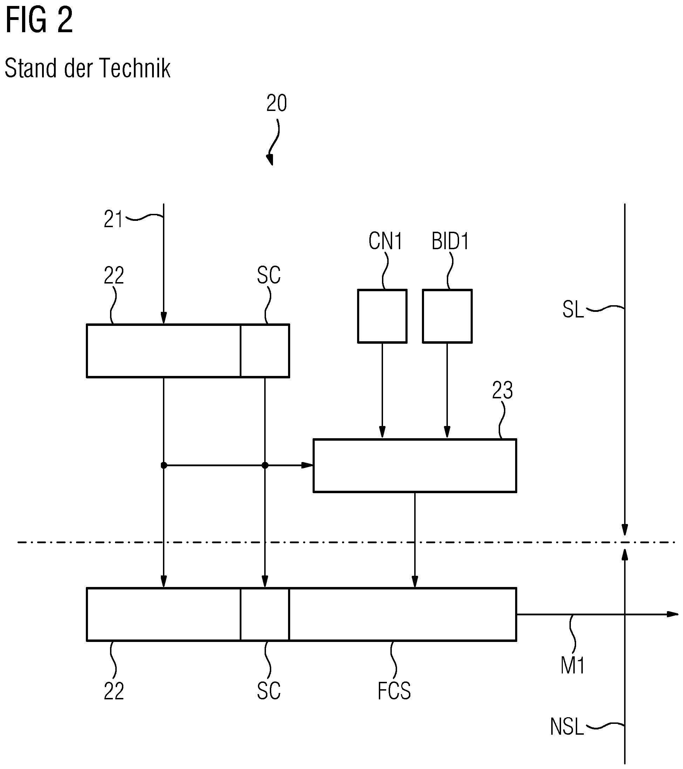

Die FIG 2 (Stand der Technik) zeigt einen Ablauf in einem Sender, nämlich dem ersten Automatisierungsgerät PLC1, wie es in FIG 1 dargestellt ist.

Dabei werden sicherheitsrelevante Operationen in einem Sicherheitslayer SL und nicht sicherheitsrelevante Operationen, wie das Verschicken des Telegramms in einen -Nicht-Sicherheitslayer NSL ausgeführt. Das Verschicken eines Telegramms erfolgt in einem sogenannten Black Channel. Gemäß FIG 2 werden in dem Sicherheitslyer SL aus zu versendenen Daten 21 in einem Paket User-Daten 22 mit einem Statusbyte SC zusammengefasst. Diese beiden Daten werden mittels einer Prüfsummenberechnung 23 unter Zuhilfenahme einer CRC-Rechnung, wobei der Codename CN1 und die erste Basiskennung BID1 mit in die Prüfsummenberechnung mit einfließen. Aus dieser Berechnung entsteht eine Blockprüfzeichenfolge FCS, welche mit den User-Daten 22 und dem Statusbyte SC als eine zu sendende Nachricht Ml versendet werden.

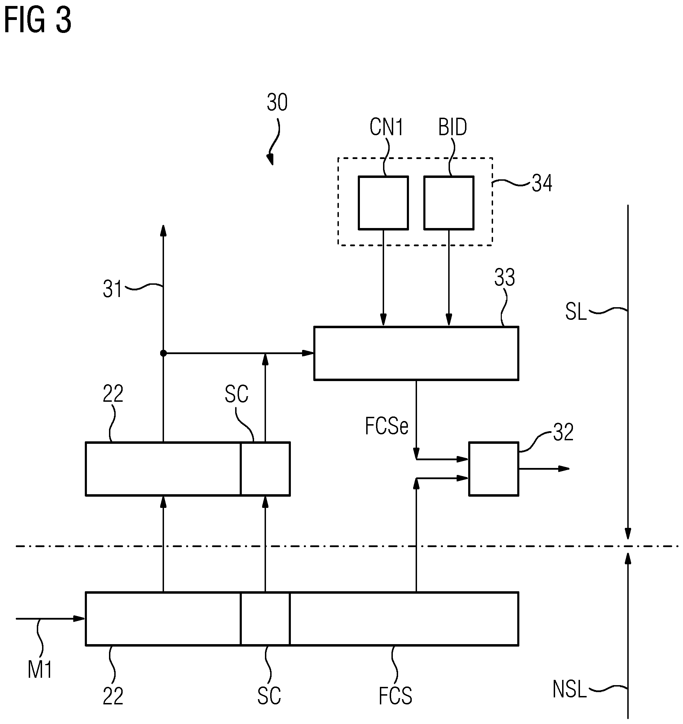

Gemäß FIG 3 ist als Gegenstück zu dem in FIG 2 beschriebenen Sendevorgang der Nachricht Ml nun ein Empfangsvorgang 30 dargestellt. Die nun empfangene Nachricht Ml gliedert sich in User-Daten 22, dem Statusbyte SC und der Blockprüfzeichenfolge FCS. Die zuvor genannten Daten befinden sich noch in dem Nicht-Sicherheitslayer NSL. Nun werden zur Auswertung die Daten in den Sicherheitslayer SL verfrachtet. Aus den User-Daten 22 und dem Statusbyte SC wird innerhalb des Sicherheitslayer SL mittels einer Prüfsummenprüfung eine Blockprüfzeichenfolge FCSₑ als erwarteter berechneter Wert zurückgerechnet. Dieser erwartete zurückgerechnete Blockprüfzeichenfolgewert FCSₑ wird mit der in der Nachricht Ml enthaltenen Blockprüfzeichenfolge FCS über ein Vergleichsmittel 32 verglichen, bei Ungleichheit wird ein Fehler signalisiert und das bedeutet, es lag ein Adressierfehler vor.

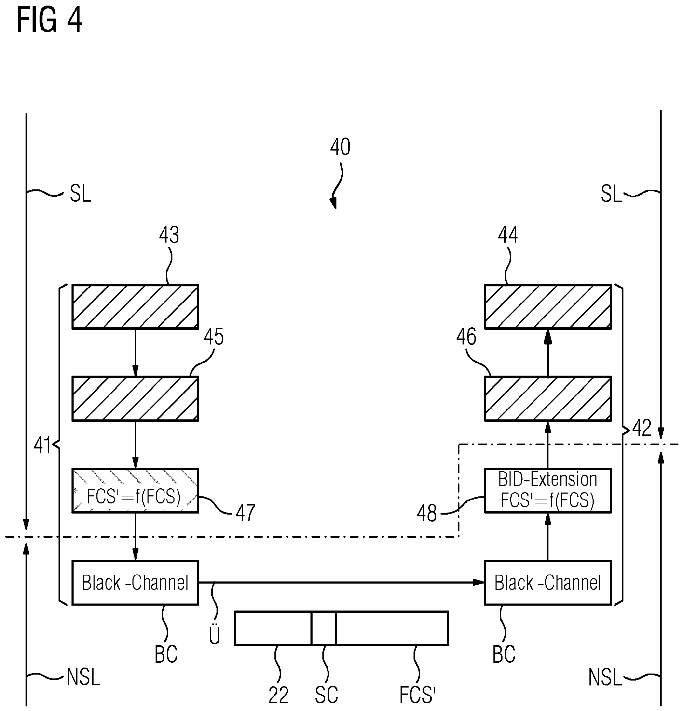

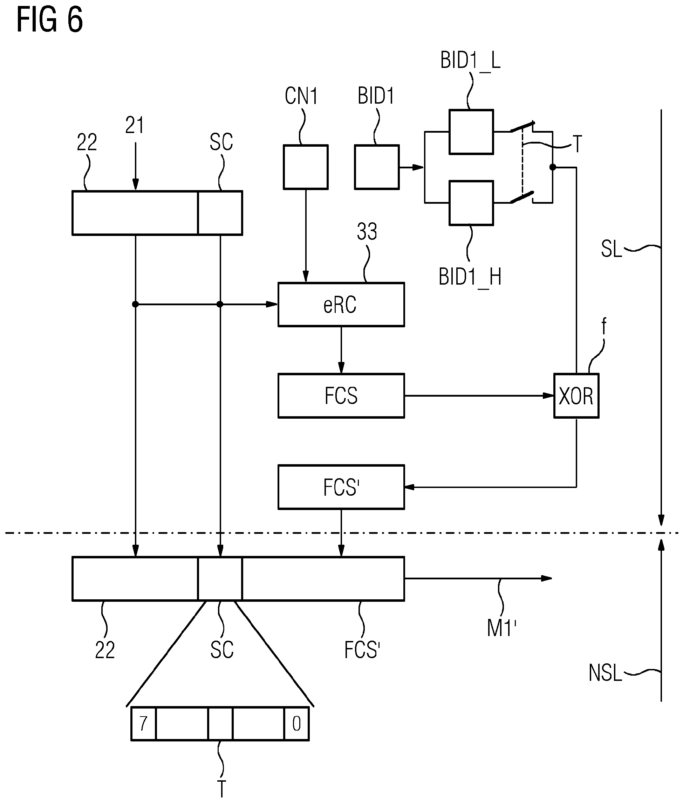

Mit der FIG 4 wird eine Übersicht 40 über die erfindungsgemäße Erweiterung einer Prüfung für eine Basiskennung gezeigt. Auch in der FIG 4 ist durch eine Strich-Punkt Linie wieder eine Unterscheidung aus Sicherheitslayer SL und Nicht-Sicherheitslayer NSL eingeführt worden. Linksseitig ist exemplarische eine Senderseite dargestellt, welche in dem Beispiel bezogen auf FIG 1, dem ersten Automatisierungsgerät PLC1 entspricht. Eine Senderapplikation 43 steht mit einem PROFIsafe-Treiber-Sender (Host) 45 in Verbindung. Um nun das erfindungsgemäße Verfahren zu implementieren, wird eine Basiskennung-Erweiterung (senderseitig) 47 zwischen einem Black-Channel BC und dem PROFIsafe-Treiber 45 angeordnet. Mit der Basiskennung-Erweiterung 47 wird, wie später in FIG 6 detailliert erklärt wird, eine neue Blockprüfzeichenfolge FCS' generiert in der Anteile von der ersten Basiskennung BID erhalten um später für eine erweiterte Adressierfehleraufdeckung die Basiskennung BID hinzuzunehmen. Über einen Übertragungsweg Ü wird nun das erweiterte Telegramm bzw. des Telegramms, welches mit einer veränderten Blockprüfzeichenfolge FCS' angereichert ist, verschickt. Das Telegramm bzw. die Nachricht Ml enthält User-Daten 22, ein Statusbyte SC und die veränderte, neue Blockprüfzeichenfolge FCS'. Der Empfänger entspricht dem beispielsweise ersten Feldgerät D1 aus FIG 1, rechte Seite des Blockschaltbildes. Die strichpunktierte Linie, welche die Unterscheidung zwischen den Sicherheitslayer SL und den Nicht-sicherheitslayer NSL bildet, hat sich empfängerseitig leicht verschoben, dieses zeigt auch den entscheidenden Vorteil der Erfindung. Denn, eine BasiskennungsErweiterung (empfängerseitig) 48 muss nun nicht mehr, wie zuvor in FIG 1 beschrieben, in einem Sicherheitslyer SL implementiert werden, sondern kann in einem Nicht-sicherheitslayer NSL implementiert bzw. untergebracht sein, dieses bietet den entscheidenden Vorteil, dass bei vorhandenen Feldgeräten ein PROFIsafe Treiber (Device) 46 nicht mehr entwicklungstechnisch nachgebessert bzw. verändert und neu getestet werden muss. Im Empfänger befindet sich oberhalb des PROFIsafe Treibers 46 ebenfalls eine Empfängerapplikation 44.

Mit der FIG 6 wird der nunmehr neue Sendevorgang 60 bzw. eine Aufbereitung einer Nachricht Ml mit einer veränderten, neuen Blockprüfzeichenfolge FCS' gezeigt.

Um nun in einen Automatisierungsgerät PLC1 eine sichere Kommunikation im Hinblick auf die Aufdeckung von Adressierung von Fehlern zu realisieren, wird bei der Sendung einer Nachricht Ml zu einem Feldgerät D1 ein erster Codename CN1 und eine erste Basiskennung BID1 folgendermaßen in die Nachricht M1 bzw. in das zu versendende Telegramm eingearbeitet.

Auf Seiten des ersten Automatisierungsgerät PLC1 (Host) ist der Codename für die Verbindung zu den ersten Feldgerät D1 bekannt, nämlich der erste Codename CN1. Auch ist die erste Basiskennung BID1 des Automatisierungsgerätes PLC1 bekannt. Für die fehlersichere Kommunikations-Verbindung wird demnach eine F-Adresse F-Adr genutzt, welche zum einen den ersten Codenamen CN1 und zum anderen die erste Basiskennung BID1 umfasst, dabei wird für das Senden der Nachricht M1 von dem ersten Automatisierungsgerät PLC1 zu dem ersten Feldgerät D1 mit Hilfe einer Prüfsummenberechnung 33,CRC aus zu versendenen Daten 21 und aus einem Statusbyte SC unter Einwirkung des für die jeweilige Verbindung vergebenen ersten Codenamen CN1, eine Blockprüfzeichenfolge FCS gebildet.

Ausgehend von dem ersten Automatisierungsgerät PLC1 mit der ersten Basiskennung BID1 als Sender der Nachricht M1 für das erste Feldgerät D1 als Empfänger, wird nun aus der bereits berechneten Blockprüfzeichenfolge FCS eine neue Blockprüfzeichenfolge FCS' generiert. Diese Generierung erfolgt folgendermaßen: Unter Anwendung einer Rechenregel F mit zumindest einem Wert BID1_L, BID1_H, welcher aus der ersten Basiskennung BID1 abgeleitet wurde, wird die Blockprüfzeichenfolge FCS mit der Rechenregel und dem Wert verändert hin zu einer neu berechneten Blockprüfzeichenfolge FCS'. Diese neu generierte Blockprüfzeichenfolge FCS' wird in der Nachricht M1 versendet.

Eine alternative Möglichkeit für die Benutzung eines abgeleiteten Wertes aus der Basiskennung BID1 besteht darin, dass zur Generierung der neuen Blockprüfzeichenfolge FCS' ein Toggle-Bit T aus dem Statusbyte SC genutzt wird, um abwechselnd entweder den ersten Wert BID1_L oder den zweiten Wert BID1_H zu verwenden.

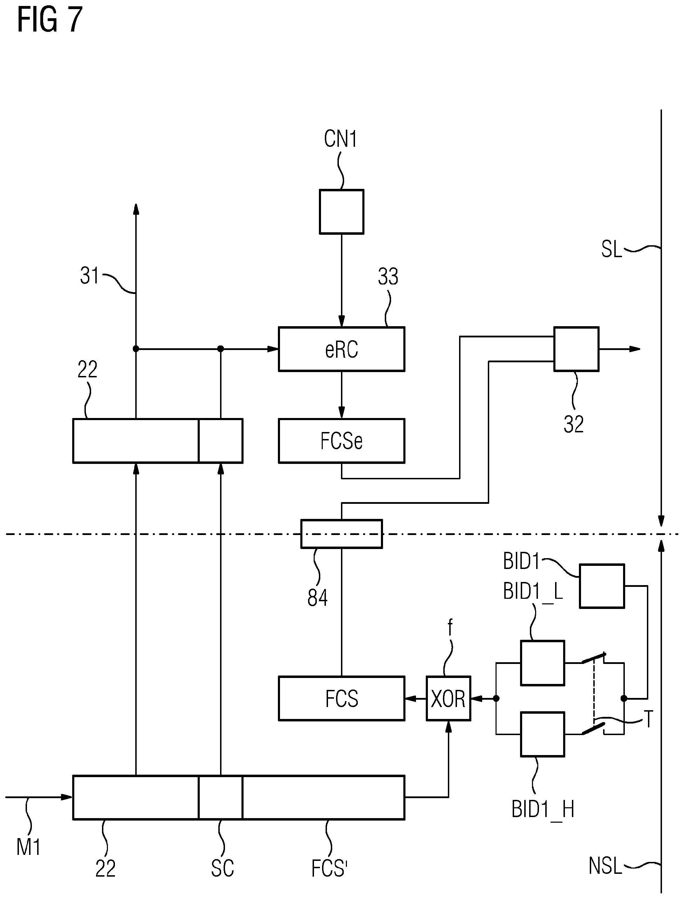

Mit der FIG 7 wird nun das Empfangsprinzip der Nachricht M1 bzw. M1' erklärt. Die erhaltene Nachricht M1' weist in ihrem Telegramm nun die User-Daten 22, das Statusbyte SC und die neue Blockprüfzeichenfolge FCS' auf.

Auch die FIG 7 ist wieder durch eine strichpunktierte Linie in einen Sicherheitslayer SL und einen Nicht-Sicherheitslayer NSL aufgeteilt. Das besondere hierbei ist, dass die Rückrechnung von der neuen Blockprüfzeichenfolge FCS' in die herkömmliche Blockprüfzeichenfolge FCS nun in dem Nicht-Sicherheitslayer NSL durchgeführt wird. In dem Feldgerät D1, auf das jetzt beispielsweise dieser mit FIG 7 dargestellte Empfangsvorgang abgebildet wird, ist die erste Basiskennung BID1 bekannt, darum kann in dem Nicht-Sicherheitslayer NSL aus der ersten Basiskennung wieder ein erster Wert oder ein zweiter Wert BID1_L, BID1_H generiert werden, welcher unter Zuhilfenahme der Rechenregel mit der empfangenen neuen Blockprüfzeichenfolge FCS' verknüpft wird und dadurch erhält man die originale Blockprüfzeichenfolge FCS, welche dementsprechend aus der neuen veränderten Blockprüfzeichenfolge FCS' zurückgerechnet wurde.

Nun kann das Ergebnis der zurückgerechneten Blockprüfzeichenfolge FCS über eine Schnittstelle 84 von dem Nicht-Sicherheitslayer NSL in den Sicherheitslayer SL gebracht werden. In dem Sicherheitslayer SL können nun sicherheitsgerichtet die weiteren Operationen zur Aufdeckung von Adressierfehlern durchgeführt werden. Dazu werden mit Hilfe einer Prüfsummenprüfung 34,CRC aus den zu empfangenen Daten 22 und dem Statusbyte unter Einwirkung des für diese Verbindung vergebenen ersten Codenamen CN1 eine erwartete Prüfzeichenfolge FCSₑ errechnet. Die erwartete Blockprüfzeichenfolge FCSₑ wird mit der zurückgerechneten Blockprüfzeichenfolge FCS verglichen, und bei Ungleichheit wird über das Vergleichsmittel 32 eine Fehlermeldung generiert.

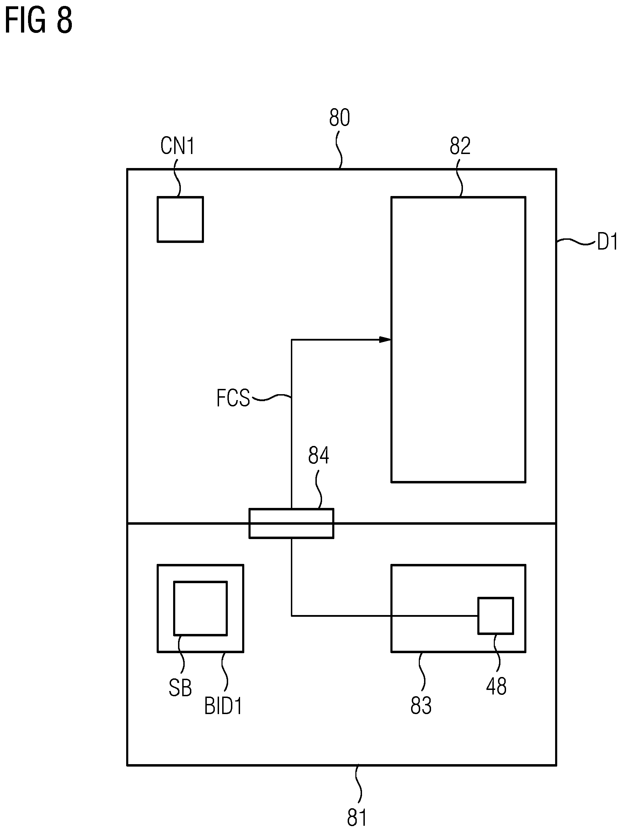

Die FIG 8 zeigt ein Feldgerät D1, welches unterteilt ist, in eine sichere Schicht 80 und in eine nicht sichere Schicht 81. In der sicheren Schicht 80 sind sicherheitsbezogene Softwareanteile 82 und der erste Codename CN1 hinterlegt. So ist es auch üblich bei bisher betriebenen PROFIsafe-Feldgeräten.

In der nicht sicheren Schicht 81 ist nun ein Speicherbereich SB vorgesehen, in welchen die jeweilige Basiskennung BID, in diesem Fall die erste Basiskennung BID1 abgespeichert ist. Zusätzlich befinden sich in der nicht sicheren Schicht 81 ein Zusatz-Mittel 83 zur Aufnahme einer Basiskennungs-Erweiterung 48. Die Basiskennungs-Erweiterung 48 ist ausgestaltet, zur Aufdeckung eines Adressierungsfehlers, dabei wird zunächst aus der in der Nachricht M1 enthaltenen Blockprüfzeichenfolge FCS' unter Zuhilfenahme der Rechenregel F mit dem Wert BID_L,BID_H, welcher jetzt aus der abgespeicherten ersten Basiskennung BID1 abgeleitet wird, die Blockprüfzeichenfolge FCS zurückzurechnen.

Über eine Schnittstelle 84 kann die zurückgerechnete Blockprüfzeichenfolge FCS in die sichere Schicht 80 übertragen werden und in den sicherheitsbezogenen Softwareanteilen 82 kann wie bisher bekannt oder auch mit FIG 3 bzw. FIG 7 erläutert, nun über die CRC-Prüfung und den späteren Vergleich der beiden Blockprüfzeichenfolgen ein möglicher Adressierfehler aufgedeckt werden.

Der entscheidende Vorteil dieses Verfahrens oder einer Implementierung in ein bestehendes Feldgerät ist, dass keine Änderungen an sicherheitsrelevanten Teilen vorgenommen werden müssen.

## Patentansprüche

1. Verfahren zur Aufdeckung von Adressierungsfehlern bei einer fehlersicheren Kommunikations-Verbindung zwischen einem Automatisierungsgerät (PLC1,PLC2) und einem Feldgerät (D1,-D2,D3), wobei für die fehlersichere Kommunikations-Verbindung eine F-Adresse (F-Adr) genutzt wird, welche einen Codenamen (CN1,CN2,CN3) und eine Basiskennung (BID1,BID2,BID3) umfasst, wobei für das Senden einer Nachricht (M1) von dem Automatisierungsgerät (PLC1,PLC2) zu dem Feldgerät (D1,D2,D3) mit Hilfe einer Prüfsummenberechnung (33,CRC) aus zu versendenden Daten (21) und aus einem Statusbyte (SC) unter Einwirkung des für die jeweilige Verbindung vergebenen Codenamen (CN1,CN2,-CN3) eine Blockprüfzeichenfolge (FCS) gebildet wird,
**dadurch gekennzeichnet, dass**
- ausgehend von einem ersten Automatisierungsgerät (PLC1) mit einer ersten Basiskennung (BID1) als Sender der Nachricht (M1) für ein erstes Feldgerät (D1) als Empfänger der Nachricht (M1) aus der bereits berechneten Blockprüfzeichenfolge (FCS) eine neue Blockprüfzeichenfolge (FCS') generiert wird, wobei eine Anwendung einer Rechenregel (f₍₎) mit zumindest einem Wert (BID1_L,BID1_H, welcher aus der ersten Basiskennung (BID1) abgeleitet wurde, auf die Blockprüfzeichenfolge (FCS) die neue Blockprüfzeichenfolge (FCS) ergibt, und die derart berechnete neue Blockprüfzeichenfolge (FCS') wird in der Nachricht (M1) versendet,
- wobei zur Aufdeckung eines Adressierungsfehlers im ersten Feldgerät (D1) zunächst aus der neuen Blockprüfzeichenfolge (FCS') unter Zuhilfenahme der Rechenregel (f₍₎) mit dem zumindest einen Wert (BID_L,BID_H) die Blockprüfzeichenfolge (FCS) zurückgerechnet wird und mit Hilfe einer Prüfsummenprüfung (34,CRC) aus den zu empfangenen Daten (22) und aus dem Statusbyte (SC) unter Einwirkung des für diese Verbindung vergebenen ersten Codenamen (CN1) eine erwartete Blockprüfzeichenfolge (FCSₑ) errechnet wird,
- wobei die erwartete Blockprüfzeichenfolge (FCSₑ) mit der zurückgerechneten Blockprüfzeichenfolge (FCS) verglichen wird und bei Ungleichheit wird eine Fehlermeldung erzeugt.

2. Verfahren nach Anspruch 1, wobei der Schritt bei dem aus der neuen Blockprüfzeichenfolge (FCS') unter Zuhilfenahme der Rechenregel (f₍₎) mit dem zumindest einen Wert (BID_L,BID_H) die Blockprüfzeichenfolge (FCS) zurückgerechnet wird, in einer bezogen auf einen Schichtenaufbau in dem Feldgerät (D1,D2,D3) in einem Nicht-Sicherheitslayer (NSL) durchgeführt wird, und die restlichen Schritte in einem Sicherheitslayer (SL) ausgeführt werden.

3. Verfahren nach Anspruch 1 oder 2, wobei aus der Basiskennung (BID1) ein erster Wert (BID_L) und ein zweiter Wert (BID_H) abgeleitet wird und der erste Wert einer ersten Rangfolge von Bits und der zweite Wert (BID_H) einer zweiten Rangfolge von Bits der Basiskennung (BID) entspricht.

4. Verfahren nach Anspruch 3, wobei zur Generierung der neuen Blockprüfzeichenfolge (FCS') ein Toggle-Bit (T) aus dem Statusbyte (SC) genutzt wird um abwechselnd entweder den ersten Wert (BID_L) oder den zweiten Wert (BID_H) zu verwenden.

5. Verfahren nach einem der Ansprüche 1 bis 4, welches in Feldgeräten (D1,D2,D3) angewendet wird, welche als sicherheitsbezogene Geräte für die Prozessautomatisierung ausgelegt sind, wobei das Verfahren ausgeführt werden kann ohne Änderungen an sicherheitsbezogenen Software-Schichten des Gerätes vorzunehmen vornehmen zu müssen.

6. Feldgerät (D1,D2,D3) ausgestaltet zur Aufdeckung von Adressierungsfehlern bei einer fehlersicheren Kommunikations-Verbindung mit einem Automatisierungsgerät (PLC1,PLC2), wobei für die fehlersichere Kommunikations-Verbindung eine F-Adresse (F-Adr) genutzt wird, welche einen Codenamen (CN1,CN2,CN3) und eine Basiskennung (BID1,BID2,BID3) umfasst,
wobei für das Senden einer Nachricht (M1) von dem Automatisierungsgerät (PLC1,PLC2) zu dem Feldgerät (D1,D2,D3) mit Hilfe einer Prüfsummenberechnung (33,CRC) aus zu versendenden Daten (21) und aus einem Statusbyte (SC) unter Einwirkung des für die jeweilige Verbindung vergebenen Codenamen (CN1,CN2,CN3) eine Blockprüfzeichenfolge (FCS) gebildet wird, und wobei durch eine Anwendung einer Rechenregel (f₍₎) mit zumindest einem Wert (BID_L,BID_H, welcher aus der jeweiligen Basiskennung (BID1) abgeleitet wurde, auf die Blockprüfzeichenfolge (FCS) eine neue Blockprüfzeichenfolge (FCS) ergibt, und die derart berechnete neue Blockprüfzeichenfolge (FCS') ist in der Nachricht (M1) enthalten und wird so vom Feldgerät (D1,D2,D3) empfangen,
weiterhin ausgestaltet mit einer Aufteilung in eine sichere Schicht (80), in welcher sicherheitsbezogene Softwareanteile (82) ablauffähig hinterlegt sind, und in eine nicht sichere Schicht (81) in der losgelöst von den sicherheitsgerichteten Aufgaben nicht auf Sicherheit ausgelegte Anwendungen ablaufen, wobei
in der nicht sicheren Schicht (81)
- ein Zusatz-Mittel (83) zur Aufnahme einer Basiskennungs-Erweiterung (48) vorhanden ist, und
- ein Speicherbereich (SB) vorhanden ist, in welcher für die fehlersichere Kommunikationsverbindung die zugehörige Basiskennung (BID1) abgespeichert ist, und
- die Basiskennungs-Erweiterung (48) ausgestaltet ist zur Aufdeckung eines Adressierungsfehlers zunächst aus der in der Nachricht (M1) enthaltenen Blockprüfzeichenfolge (FCS') unter Zuhilfenahme der Rechenregel (f₍₎) mit dem Wert (BID_L,BID_H), welcher jetzt aus der abgespeicherten Basiskennung (BID1) abgeleitet wird, die Blockprüfzeichenfolge (FCS) zurückzurechnen, und
in der sicheren Schicht (80)
- ein Mittel zur Prüfsummenprüfung (33) vorhanden ist, welches aus den zu empfangenen Daten (22) und aus dem Statusbyte (SC) unter Einwirkung des für diese Verbindung vergebenen ersten Codenamen (CN1) eine erwartete Blockprüfzeichenfolge (FCSₑ) errechnet und
- eine Schnittstelle (84) vorhanden ist, welche ausgestaltet ist die erwartete Blockprüfzeichenfolge (FCSₑ) aus der nicht sicheren Schicht (81) entgegen zu nehmen, und
- ein Vergleichsmittel (32) vorhanden ist, welches die erwartete Blockprüfzeichenfolge (FCSₑ) mit der zurück gerechneten Blockprüfzeichenfolge (FCS) vergleicht.
